# EUROPEAN PATENT APPLICATION

(11) **EP 1 475 825 A1**
(43) Date of publication of application: **10.11.2004**
(21) Application number: 03729550.8
(22) Date of filing: 17.01.2003
(51) Int. Cl.: H01L 21/283, H01L 21/205, C23C 16/52

(54) **PROCESSING DEVICE AND PROCESSING METHOD**

(30) Priority: 17.01.2002 JP 2002008465
(71) Applicant: TOKYO ELECTRON LIMITED, Minato-ku, Tokyo 107-8481 (JP)
(72) Inventor: KANNAN, Hiroshi, Minato-ku, Tokyo 107-8481 (JP); MATSUOKA, Takaaki, Minato-ku, Tokyo 107-8481 (JP)
(74) Representative: Liesegang, Eva
(86) International application number: PCT/JP2003/000363
(87) International publication number: WO 2003/060969

(57) **Abstract**

An exhaust line (15) connected to a chamber (13) comprises a TMP (22) and a dry pump (23). The chamber (13) and the TMP (22) are connected by a first exhaust pipe (25), and the TMP (22) and the dry pump (23) are connected by a second exhaust pipe (28). A measuring section (24) monitors a partial pressure of TiCl₄ or NH₃ in an exhaust gas flowing in the second exhaust pipe (28). Two types of process gases are alternately supplied into the chamber (13) for a predetermined time, and when the partial pressure of one of the supplied process gases in the exhaust gas is reduced to a predetermined value, a control means (12) starts supplying the other process gas.

## Description

### Technical Field

The present invention relates to a processing device and processing method which perform a predetermined process, such as deposition, on a process target such as a semiconductor wafer.

### Background Art

At present, micronization and large scale integration of semiconductor integrated circuits advance miniaturization of patterns, such as wiring grooves formed in the substrate surface of a substrate or the like. In case where a thin film is formed as an underlayer of wiring metal, therefore, it is demanded to form a very thin film in a fine patterned wiring groove uniformly with a good coverage. In accordance with this demand, a method called atomic layer deposition (Atomic Layer Deposition; ALD) has recently been developed as a method capable of forming a good-quality film of an atomic layer level.

ALD comprises the following steps, for example. In the example illustrated below, a description is given of a case where an underlayer of titanium nitride is formed on the top surface of a substrate on which a wiring pattern (wiring grooves) is formed by using a titanium tetrachloride gas and ammonia gas.

First, the substrate is placed in a chamber and the chamber is vacuumed out. Subsequently, a titanium tetrachloride gas is introduced into the chamber. Accordingly, titanium tetrachloride molecules are adsorbed to a multi-atomic layer on the top surface of the substrate. Thereafter, inside the chamber is purged with an inactive gas, thereby removing titanium tetrachloride from inside the chamber but leaving the titanium tetrachloride molecules for nearly one atomic layer adsorbed on the top surface of the substrate.

After purging, an ammonia gas is introduced into the chamber. Accordingly, the titanium tetrachloride molecules adsorbed on the top surface of the substrate react with ammonia molecules, forming a titanium nitride layer for nearly one atomic layer on the top surface of the substrate. At this time, ammonia molecules are adsorbed to a multi-atomic layer on the formed titanium nitride layer. Thereafter, inside the chamber is purged with an inactive gas to remove ammonia from inside the chamber, leaving the ammonia molecules for nearly one atomic layer adsorbed on the titanium nitride layer.

Subsequently, a titanium tetrachloride gas is introduced into the chamber again. Accordingly, the adsorbed ammonia molecules react with the titanium tetrachloride molecules, forming a new titanium nitride layer for one atomic layer. That is, a titanium nitride layer for approximately two one atomic layers is formed in this state.

At this time, titanium tetrachloride molecules are adsorbed onto the titanium nitride layer. Thereafter, the atmosphere inside the chamber is alternately changed, like purging inside the chamber with an inactive gas brings about a state in which titanium tetrachloride for nearly one atomic layer is adsorbed on the titanium nitride layer. Thereafter, introduction of an ammonia gas, purging, introduction of titanium tetrachloride, purging, ..., to form a titanium nitride layer with a thickness equivalent to a predetermined atomic layer. For example, a titanium nitride layer of several nm to several tens of nm can be formed by changing the atmosphere inside the chamber by several tens to several hundred times. Vacuum pumping may be carried out in place of purging with an inactive gas.

In ALD, switching between supply of a gas into the chamber and stopping is executed based on a process sequence acquired previously from experiments or so regardless of the actual status in the chamber. If a next source gas is introduced before the source gas in the chamber is actually not purged sufficiently, therefore, titanium tetrachloride reacts with ammonia in vapor phase. Such a vapor phase reaction degrades the quality of a film formed on the substrate. It is therefore desirable to control gas supply based on information indicating the actual status in the chamber.

As a method of controlling a process based on information about the status in a chamber, there is a method of providing a measuring device, which acquires predetermined information, e.g., information on the concentration of a predetermined matter, from an exhaust gas, in an exhaust line which vacuums the chamber. For example, Unexamined Japanese Patent Application KOKAI Publication No. H9-134912 discloses a semiconductor manufacture apparatus which detects the concentration of a predetermined matter in the exhaust gas and controls in such a way as to make the concentration of the predetermined matter in the chamber constant.

Here, the exhaust line has a main pump, such as a turbo molecular pump (TMP), connected to the chamber and a sub pump (roughing pump), such as a dry pump (DP) connected to the main pump. The sub pump depressurizes inside the chamber to a vacuum state to a level at which the main pump is operable, then the main pump depressurizes to a high vacuum state. In the structure that acquires predetermined information from the exhaust gas, the measuring device is provided on the supply side of the TMP of the exhaust line.

However, the supply side of the TMP is in a low pressure state approximately the same as the state of the chamber and the concentration of the substance in the exhaust gas is low. As the pipe that connects the chamber to the TMP has a relatively large diameter in accordance with the suction performance of the TMP, a variation in the concentration of the substance in the exhaust gas becomes relatively large. Therefore, a sufficiently high measuring sensitivity cannot be acquired, and the measured value varies depending on the detection position so that highly reliable information may not be obtained. In such a case, the reliability of the process falls, such as reduction in film quality, particularly, in ALD that forms a precise film of an atomic layer level.

The same can be true of a process system which performs other processes, such as deposition and etching, besides ALD. That is, as described in Unexamined Japanese Patent Application KOKAI Publication No. H6-120149 or the like, a process system which disposes a particle monitor device which detects particles in the exhaust line and monitors the amount of particles in the exhaust is disclosed. In this case, as the exhaust pipe has a relatively large diameter, a variation in the distribution of particles in the exhaust pipe becomes larger, disabling the high precision detection of the amount of particles, which leads to a possibility that the reliability of the process drops.

As apparent from the above, as the conventional process system, which acquires predetermined information from an exhaust gas and controls a process based on the acquired information, acquires predetermined on the supply side of the main pump which is at a low pressure and has a relatively large pipe diameter, there is a possibility that information with a sufficient high reliability is not obtained and process control with high precision is not performed.

### Disclosure of Invention

In view of the above situations, the present invention aims at providing a processing device and processing method which acquire predetermined information from an exhaust gas in a chamber and can execute process control with high precision based on the acquired information.

To achieve the object, a processing device according to the first aspect of the invention is characterized by having:
process means which has a chamber and performs a predetermined process on a process target in the chamber;
first exhaust means which is connected to the chamber and pumps inside the chamber to a predetermined vacuum pressure;
second exhaust means which is connected to the first exhaust means and pumps inside the chamber to a pressure at which the first exhaust means is operable;
information acquisition means which is arranged between the first exhaust means and the second exhaust means and acquires information about a predetermined matter in an exhaust gas exhausted from the chamber; and
control means which discriminates a status inside the chamber based on the information acquired by the information acquisition means and controls the process means.

In the above-described structure, information (e.g., concentration) on a predetermined matter in an exhaust gas flowing between the first exhaust means (e.g., a turbo molecular pump) and the second exhaust means (e.g., dry pump) which operates at a higher pressure than the first exhaust means is acquired. Because the pressure on the exhaust side of the first exhaust means (between the first exhaust means and the second exhaust means) becomes higher (the degree of vacuum is lower) than that on the inlet side of the first exhaust means (between the chamber and the first exhaust means), the concentration of the matter in the exhaust gas flowing in this portion becomes relatively higher, improving the analysis sensitivity. Therefore, highly reliable information can be acquired and high-precision process control is performed.

To achieve the object, a processing device according to the second aspect of the invention is characterized by having:
a process section which has a chamber and performs a predetermined process on a process target in the chamber;
a first exhaust section which is connected to the chamber via a first exhaust pipe and pumps inside the chamber to a predetermined vacuum pressure;
a second exhaust section which is connected to an exhaust side of the first exhaust section via a second exhaust pipe smaller in diameter than the first exhaust pipe and pumps inside the chamber to a pressure at which the first exhaust section is operable;
an information acquisition section which acquires information about a predetermined matter in an exhaust gas exhausted from the chamber and flowing in the second exhaust pipe; and
a control section which discriminates a status inside the chamber based on the information acquired by the information acquisition section and controls the process section.

In the above-described structure, information (e.g., concentration and the amount of particles) on a predetermined matter in an exhaust gas flowing in the second exhaust pipe of a relatively small diameter that connects the first exhaust means (e.g., a turbo molecular pump) to the second exhaust means (e.g., dry pump) which operates at a higher pressure than the first exhaust means is acquired. Because the concentration of a matter is relatively high in the second exhaust pipe whose pressure is higher (the degree of vacuum is lower) than that in the first exhaust pipe and which is smaller in diameter than the first exhaust pipe and its variation is small, highly reliable information can be acquired and high-precision process control is performed.

The processing device may further have a measurement pipe which is branched from the second exhaust pipe and bypasses the exhaust gas flowing in the second exhaust pipe and the information acquisition section may acquire the information from the exhaust gas flowing in the measurement pipe.

The processing device may have an infrared spectroscopic analysis device or a mass spectrometry device which measures a concentration of the predetermined matter in the information acquisition section and the control section may control the process section based on the concentration of the predetermined matter measured by the information acquisition section. Here, the infrared spectroscopic analysis device is preferably a Fourier transform infrared spectroscopic device (FT-IR) and the mass spectrometry device is desirably a quadrupole mass spectrometry.

The processing device may have an infrared spectroscopic analysis device which measures a distribution of a fragment matter in the exhaust gas in the information acquisition section and the control section may control the process section based on the distribution of the fragment matter measured by the information acquisition section. Here, the infrared spectroscopic analysis device is preferably a Fourier transform infrared spectroscopic device (FT-IR).

To achieve the object, a processing device according to the third aspect of the invention is characterized by having:
a chamber;
gas supply means which is connected to the chamber and supplies one process gas in a plurality of process gases into the chamber for a predetermined time;
first exhaust means which is connected to the chamber and pumps inside the chamber to a predetermined vacuum pressure;
second exhaust means which is connected to the first exhaust means and pumps inside the chamber to a pressure at which the first exhaust means is operable;
measuring means which is arranged between the first exhaust means and the second exhaust means and measures an amount of the process gas in an exhaust gas exhausted from the chamber; and
control means which controls supply of another process gas by the gas supply means based on the amount of the process gas measured by the measuring means.

That is, as the processing device with the above-described structure is adaptable to a process, such as an atomic layer deposition (ALD), which performs a process by repeatedly replacing the gas atmosphere in the chamber and can control gas switching with high accuracy, it can execute a process with a high reliability and high productivity.

In the processing device, the control means starts supplying another process gas into the chamber by the gas supply means when the amount of the process gas in the exhaust gas is reduced to a predetermined amount.

To achieve the object, a processing device according to the fourth aspect of the invention is characterized by having:
a chamber in which a predetermined process is performed on a process target;
cleaning means which cleans inside the chamber by supplying a cleaning gas for purifying inside the chamber;
first exhaust means which is connected to the chamber and pumps inside the chamber to a predetermined vacuum pressure;
second exhaust means which is connected to the first exhaust means and pumps inside the chamber to a pressure at which the first exhaust means is operable;
information acquisition means which is arranged between the first exhaust means and the second exhaust means and acquires information about a pollutant in an exhaust gas exhausted from the chamber; and
control means which discriminates a pollution status inside the chamber based on the information acquired by the information acquisition means and controls the cleaning means.

That is, as the processing device with the above-described structure is adaptable to dry cleaning of the chamber and can control cleaning with high accuracy, efficient cleaning with excessive cleaning or so prevented is possible.

In the above-described structure, the pollutant may be, for example, particles and the control means may clean inside the chamber when an amount of the particles in the exhaust gas becomes equal to or greater than a predetermined amount. Here, it is desirable that the information acquisition means should have an optical counter as a device which measures the amount of particles.

The processing device may further have byproduct measuring means, which measures an amount of a byproduct produced by the cleaning in the exhaust gas, in the information acquisition means and the control means may control the cleaning means based on the amount of the byproduct measured by the byproduct measuring means. Here, the byproduct measuring means is preferably a quadrupole mass spectrometer or FT-IR

The processing device may further have a mass spectrometry device, which measures a type and an amount of a metal element in the exhaust gas, in the information acquisition means and the control means may control the cleaning means based on the type and amount of the metal element measured by the information acquisition mean. Here, it is preferable that the mass spectrometry device should be a quadrupole mass spectrometer.

To achieve the object, a processing method according to the fifth aspect of the invention has:
a process step which performs a predetermined process in a chamber retaining a process target inside,
a first exhaust step which causes a main exhaust section connected to the chamber to pump inside the chamber to a predetermined vacuum pressure, and
a second exhaust step which causes a sub exhaust section connected to the main exhaust section to pump inside the chamber to a pressure at which pumping in the first exhaust step is possible, and is characterized by having:
   an information acquisition step which acquires information about a predetermined matter in an exhaust gas exhausted from the chamber in the first exhaust step and flowing between the main exhaust section and the sub exhaust section; and
   a control step which discriminates a status inside the chamber and controls the process based on the information acquired in the information acquisition step.

In the method with the above-described structure, information (e.g., concentration) on a predetermined matter in an exhaust gas flowing between the main exhaust section and the sub exhaust section which operates at a higher pressure than the main exhaust section is acquired. The pressure on the exhaust side of the main exhaust section (between the main exhaust section and the sub exhaust section) is relatively high (the degree of vacuum is low) as compared with that on the inlet side of the main exhaust section. Therefore, the concentration of the matter in the exhaust gas becomes relatively high, improving the analysis sensitivity, so that highly reliable information can be acquired and high-precision process control is performed.

### Brief Description of Drawings

Fig. 1 is a diagram showing the structure of a process system according to a first embodiment of the present invention.
Fig. 2 is a diagram showing the structure of a measuring section shown in Fig. 1.
Fig. 3 is a flowchart illustrating an operation at the time of deposition by the process system shown in Fig. 1.
Fig. 4 is a diagram showing the variation profile of partial pressures of substances in an exhaust gas.
Fig. 5 is a diagram showing the structure of a process system according to a second embodiment of the present invention.
Fig. 6 is a diagram showing the structure of a measuring section shown in Fig. 5.
Fig. 7 is a diagram showing the variation profile of the amount of particles in an exhaust gas.
Fig. 8 is a diagram showing a modification of the process system according to the second embodiment.
Fig. 9 is a diagram showing the variation profile of the amount of SiF₄ in an exhaust gas.

### Best Mode for Carrying Out the Invention

A processing device and processing method according to embodiments of the invention are described below referring to the accompanying drawings.

### (First Embodiment)

In the first embodiment, a process system which alternately supplies titanium tetrachloride (TiCl₄) gas and ammonia (NH₃) gas into the chamber with vacuum exhaust in between and deposits a titanium nitride (TiN) film on the top surface of a semiconductor wafer (hereinafter wafer) using so-called atomic layer deposition (Atomic Layer Deposition; ALD) is described as an example.

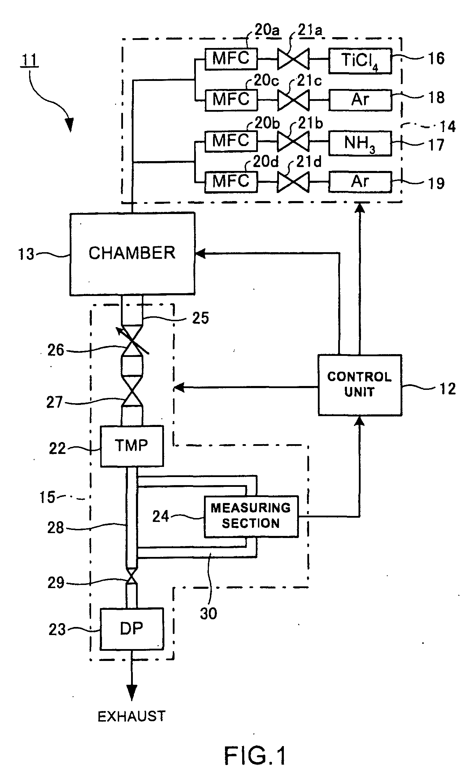

Fig. 1 shows the structure of a process system 11 according to the embodiment.

As shown in Fig. 1, the process system 11 has a control unit 12, a chamber 13, a gas supply line 14 and an exhaust line 15.

The control unit 12 controls the general operation of the process system 11 concerning deposition to be discussed later. To make understanding easier, the details of the operation of the control unit 12 are omitted.

The chamber 13 is constructed in such a way as to be vacuumable and a wafer as a process target is retained therein. An ALD process to be discussed later is performed on the wafer inside the chamber 13 to form a TiN film.

The gas supply line 14 has a TiCl₄ source 16, an NH₃ source 17 and two argon (Ar) sources 18 and 19 and the individual gas sources 16, 17, 18 and 19 are connected to flow the chamber 13 via rate control units 20a, 20b, 20c and 20d, such as MFC (Mass Flow Controller), and valves 21a, 21b, 21c and 21d, respectively. The TiCl₄ gas and NH₃ gas are supplied from the gas supply line 14 into the chamber 13, diluted with an Ar gas.

The exhaust line 15 has a turbo molecular pump (TMP) 22, a dry pump (DP) 23 and a measuring section 24. The exhaust line 15 is connected to the chamber 13 and the chamber 13 is pumped out via the exhaust line 15 to be depressurized to a predetermined pressure state.

The TMP 22 is connected to the chamber 13 via a first exhaust pipe 25. The first exhaust pipe 25 is provided with a variable flow rate valve 26 and a valve 27 in order from the chamber 13. The TMP 22 depressurizes inside the chamber 13 to a high vacuum state. The variable flow rate valve 26 keeps the interior of the chamber 13 at a predetermined high vacuum state. The first exhaust pipe 25 has an inside diameter of about, for example, 50 mm in view of the exhaust speed, the length, etc. of the TMP 22. Another pump for forming high vacuum, such as a mechanical drug pump or so, may be used in place of the TMP 22.

The dry pump 23 is connected to the exhaust side of the of the TMP 22 by a second exhaust pipe 28. A valve 29 is provided between the TMP 22 and the dry pump 23. The dry pump 23 serves as a roughing pump and sets inside the chamber 13 to a pressure at which the TMP 22 is operable. The exhaust side of the dry pump 23 is connected to an unillustrated harm eliminating device so that an exhaust gas which has passed the exhaust line 15 is made harmless and discharged out to the atmosphere.

The second exhaust pipe 28 has an inside diameter of about, for example, 40 mm in view of the exhaust speed, the length, etc. of the dry pump 23. Here, the dry pump 23 has a smaller exhaust capacity than the TMP 22 so that the second exhaust pipe 28 is smaller in diameter than the first exhaust pipe 25.

The measuring section 24 is provided in a midway of a bypass pipe 30 having both ends connected to the second exhaust pipe 28. Both ends of the bypass pipe 30 are connected to the supply side of the valve. The bypass pipe 30 has approximately the same inside diameter as that of the second exhaust pipe 28. Valves may be provided at both ends of the bypass pipe 30.

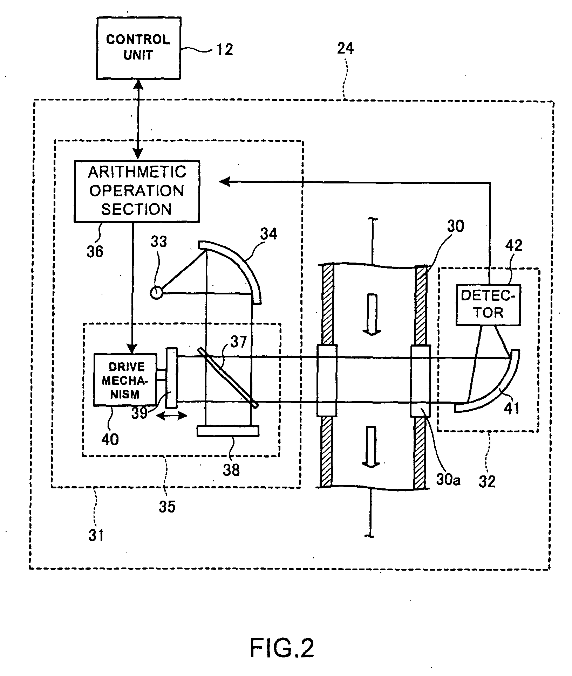

The measuring section 24 measures and monitors the partial pressure of the TiCl₄ gas and NH₃ gas in the exhaust gas passing the bypass pipe 30. The structure of the measuring section 24 is shown in Fig. 2. The measuring section 24 has the structure of a so-called FT-IR (Fourier transform infrared spectroscopic device) and comprises a main body section 31 and a detection section 32 as shown in Fig. 2.

The main body section 31 comprises a light source 33 which emits infrared light, a reflector 34 which is arranged on the optical path of the emitted light and reflects it in a predetermined direction, an interferometer 35 which is arranged on the optical path of the reflected light and an arithmetic operation section 36 connected to the control unit 12.

The interferometer 35 comprises a beam splitter 37 to which the light reflected by the reflector 34 is led and which splits the light into a plurality of lights, a fixed mirror 38 and a movable mirror 39, arranged on the respective optical paths of the lights split by the beam splitter 37, and a drive mechanism 40 which drives the movable mirror 39. The drive mechanism 40 is connected to the arithmetic operation section 36.

The detection section 32 is located on the opposite side to the main body section 31 via the bypass pipe 30. A window portion 30a formed of quartz or so is provided in the pipe wall of the bypass pipe 30 so that light emitted from the main body section 31 passes the bypass pipe 30 through the window portion 30a. The detection section 32 comprises a reflector 41 which is placed on the optical path of the light which has passed the bypass pipe 30 and reflects the light in a predetermined direction and a detector 42 which receives light reflected from the reflector 41. The detector 42 is connected to the arithmetic operation section 36 of the main body section 31.

The measuring section 24 with the above-described structure measures the partial pressures of predetermined matters in the exhaust gas, i.e., TiCl₄ and NH₃, as follows. With the infrared light emitted from the light source 33, the arithmetic operation section 36 moves the movable mirror 39 by means of the drive mechanism 40. Accordingly, the optical path difference between light input to and reflected at the movable mirror 39 and light input to and reflected at the fixed mirror 38 changes and combined lights reflected at the two mirrors 38 and 39 and combined again by the beam splitter 37 interfere with each other so that the intensity varies time-dependently. The combined light passes in the bypass pipe 30 through the window portion 30a. The light having passed the bypass pipe 30 is condensed by the reflector 41 and led to the detector 42.

The detector 42 sends light intensity data of the received light to the arithmetic operation section 36. The arithmetic operation section 36 performs Fourier transform of a time-dependent variation (interferogram) of the light intensity detected by the detector 42 and acquires infrared absorption spectrum. The arithmetic operation section 36 computes the partial pressure of a predetermined matter in the exhaust gas passing the bypass pipe 30 from the acquired infrared absorption spectrum. The arithmetic operation section 36 monitors a time-dependent variation in this partial pressure and when the partial pressure reaches a predetermined value, it sends a signal indicating that event to the control unit 12. The control unit 12 controls gas supply into the chamber 13 from the gas supply line 14 based on the received signal.

As described above, the measuring section 24 is disposed on the exhaust side of the TMP 22 and executes measurement of the partial pressures of the TiCl₄ and NH₃ in the exhaust gas on the exhaust side of the TMP 22. The exhaust side of the TMP 22 is higher in pressure than the supply side (the degree of vacuum is lower) and the matter concentration (partial pressure) in the exhaust gas is relatively high. Therefore, a measuring sensitivity higher than that in a case where measurement is taken on the supply side of the TMP 22 is acquired and information with a high reliability (partial pressure data) is acquired.

The bypass pipe 30 has the same diameter as the second exhaust pipe 28 and is smaller in diameter than the first exhaust pipe 25. Therefore, a variation in matter distribution in the bypass pipe 30 is smaller than that in case where measurement is taken on the supply side of the TMP 22, so that even optical measurement provides highly reliable information with a small variation in measured value.

As apparent from the above, based on highly reliable information acquired from the measuring section 24 provided on the exhaust side of the TMP 22, the control unit 12 can control a process such as gas switching or so in the chamber 13 with high precision. Further, it is possible to optimize the exhaust time to improve the throughput.

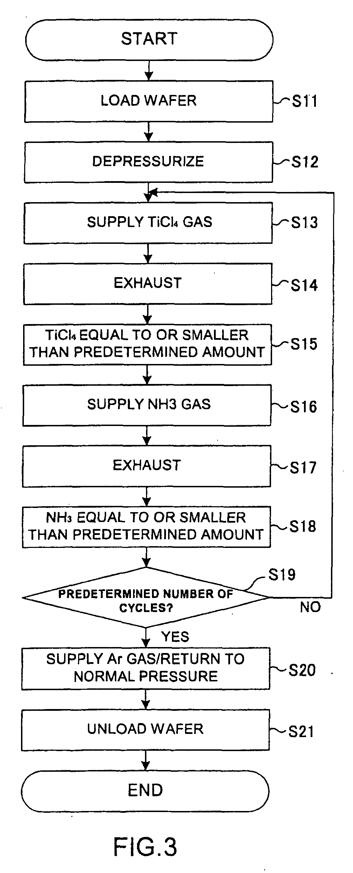

The operation of the process system 11 according to the first embodiment is described below referring to Fig. 3. The flow shown in Fig. 3 is just an example and any structure may be taken as long as similar resultant products are acquired.

First, the control unit 12 loads a wafer into the chamber 13 (step S11). Thereafter, inside the chamber 13 is depressurized to a predetermined pressure by the dry pump 23 and is further depressurized to, for example, 4 x 10² Pa (3 Torr) and maintained by the TMP 22 (step S12).

Next, the process system 11 releases the valves 21a and 21c to start supplying the TiCl₄ gas and the Ar gas (step S 13). Here, the TiCl₄ gas and Ar gas are supplied at the flow rate of, for example, TiCl₄/Ar = 30 sccm/1000s1000 sccm. The gas supply into the chamber 13 is carried out for a predetermined time, e.g., 0.5 second. The supply of the TiCl₄ gas causes TiCl₄ molecules to be adsorbed in multiple layers on the top surface of the wafer.

Thereafter, the control unit 12 closes the valves 21a and 21c to stop supplying the TiCl₄ gas and Ar gas. After gas supply is stopped, inside the chamber 13 is pumped to remove the TiCl₄ gas in the chamber 13 (step S14). At this time, pumping is executed until the partial pressure of TiCl₄ in the chamber 13 becomes sufficiently low, e.g., until the partial pressure of TiCl₄ in the exhaust gas becomes less than 10⁻¹ Pa (0.75 x 10⁻³ Torr). Pumping in the chamber 13 is carried out until the TiCl₄ molecules are removed from the chamber 13, leaving nearly one layer of TiCl₄ molecules adsorbed to the top surface of the wafer and TiCl₄ has a concentration at which TiCl₄ does not react with NH₃, supplied later, in vapor phase (step S15).

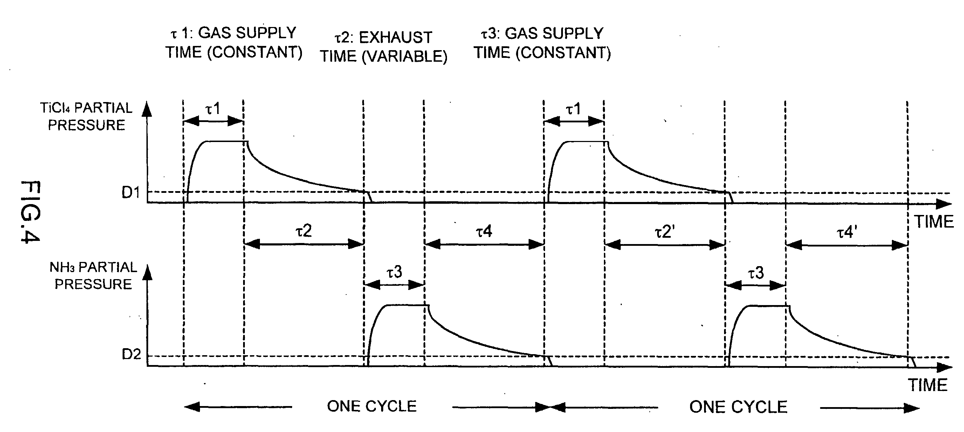

Here, the measuring section 24 always monitors the partial pressures of substances in the emission from the start of the process. Fig. 4 schematically shows the variation profile of the partial pressure of TiCl₄ and the partial pressure of NH₃ in the emission which are monitored by the measuring section 24.

As shown in Fig. 4, after the TiCl₄ gas is supplied into chamber 13 for a predetermined time (τ1), the partial pressure of TiCl₄ in the exhaust gas decreases gradually. The measuring section 24 sends a signal indicating the completion of pumping of inside the chamber 13 to the control unit 12, for example, when the partial pressure of TiCl₄ in the exhaust gas decreases to a predetermined partial pressure (D1) (after a τ2 time from the stop of the gas supply).

When receiving the signal from the measuring section 24, the control unit 12 releases the valves 21b and 21d to start supplying the NH₃ gas and the Ar gas (step S16 in Fig. 3). Here, the NH₃ gas and Ar gas are supplied at the flow rate of, for example, NH₃/Ar = 1000 sccm/100 sccm. The gas supply into the chamber 13 is carried out for a predetermined time, e.g., 0.5 second. At this time, the NH₃ molecules react with the TiCl₄ molecules adsorbed onto the wafer, forming a TiN layer for nearly one atomic layer. The NH₃ molecules are adsorbed in multiple layers onto the TiN layer.

Thereafter, the control unit 12 closes the valves 21b and 21d to stop supplying the NH₃ gas and Ar gas. After gas supply is stopped, inside the chamber 13 is pumped to remove the NH₃ gas in the chamber 13 (step S17). At this time, pumping is executed until the partial pressure of NH₃ in the chamber 13 becomes sufficiently low, e.g., until the partial pressure of NH₃ in the exhaust gas becomes less than 10⁻² Pa (0.75 x 10⁻⁴ Torr). Pumping in the chamber 13 is carried out until the NH₃ molecules are removed from the chamber 13, leaving nearly one layer of NH₃ molecules adsorbed onto the TiN layer and NH₃ has a concentration at which NH₃ does not react with TiCl₄, supplied later, in vapor phase (step S18).

As shown in Fig. 4, after the NH₃ gas is supplied into chamber 13 for a predetermined time (τ3), the partial pressure of NH₃ in the exhaust gas decreases gradually. The measuring section 24 sends a signal indicating the completion of pumping of inside the chamber 13 to the control unit 12, for example, when the partial pressure of NH₃ in the exhaust gas decreases to a reference partial pressure (D2) (after a τ4 time from the stop of the gas supply).

One cycle of steps comprised of the supply and exhaust of the TiCl₄ gas and the supply and exhaust of the NH₃ gas from step S13 to step S18 is carried out in this manner. Upon reception of the signal from the measuring section 24, the control unit 12 returns to step S13 in Fig. 3, supplies the TiCl₄ gas and Ar gas and starts a new cycle.

The control unit 12 supplies the TiCl₄ gas into the chamber 13 for a predetermined time in step S13. Accordingly, the TiCl₄ molecules react with the NH₃ molecules adsorbed onto the TiN layer, thereby newly forming a TiN layer for nearly one atomic layer. The TiCl₄ molecules are adsorbed in multiple layers onto the TiN layer.

Subsequently, the control unit 12 stops the supply of the TiCl₄ and Ar gas in step S14, thereby exhausting and removing TiCl₄ from the chamber 13. The exhaust is executed until the partial pressure of TiCl₄ decreases a predetermined partial pressure (D1) (τ2' time from the stop of gas supply) as shown in Fig. 4.

Subsequently, when receiving a signal indicating that the partial pressure of TiCl₄ in the emission reaches a predetermined partial pressure or lower from the measuring section 24 (step S15), the control unit 12 supplies the NH₃ gas and Ar gas for a predetermined time (step S16). Accordingly, the TiCl₄ molecules adhered onto the TiN layer react with the NH₃ molecules, thereby forming a new TiN layer (third layer). The NH₃ molecules are adsorbed in multiple layers onto the TiN layer.

After the supply of the NH₃ and Ar gas is stopped, the control unit 12 pumps out the chamber 13 to remove NH₃ (step S17). At this time, the exhaust is executed until the partial pressure of TiCl₄ decreases a predetermined partial pressure (D2) (τ4' time from the stop of gas supply) as shown in Fig. 4. This ends the steps of the second cycle.

As the cycles are repeated thereafter, the TiN layer is formed and laminated for nearly one atomic layer. The cycles are repeated until the TiN layer with a predetermined thickness is formed on the wafer. When it is determined in step S19 that a predetermined number of cycles are repeated, the control unit 12 supplies the process gas into the chamber 13 and sets the pressure in the chamber 13 to a predetermined pressure, e.g., nearly the same pressure as that in the wafer transport area outside the chamber 13 (step S20). Thereafter, the wafer is unloaded from inside the chamber 13 (step S21), ending the process.

According to the first embodiment, as described above, information (concentration partial pressure) in the chamber 13 is acquired from the exhaust gas on the exhaust side of the TMP 22 and a process (ALD) in the chamber 13 is controlled based on the acquired information. Because the pressure on the exhaust side of the TMP 22 is relatively high (the degree of vacuum is low) as compared with the inlet side, the measuring sensitivity is improved, or because the pipe size is relatively small, a variation or so in measured value is suppressed small. Therefore, a highly reliable process, such as keeping the film quality high, becomes possible by executing high-precision process control based on the information acquired on the exhaust side of the TMP 22.

In the first embodiment, the amount (partial pressure) of a predetermined matter in the exhaust gas is acquired using the measuring section 24 which has the structure of an FT-IR However, the means for measuring the amount of a predetermined matter is not limited to the FT-IR, but may be other measuring means, such as other optical measuring means, a concentration meter, and a mass spectrometry device like a quadrupole mass spectrometer. However, it is preferable that the infrared spectroscopic analysis device should be an FT-IR which easily acquires the infrared absorption spectrum even of a matter in a vapor phase, thus ensure efficient analysis. It is desirable that the mass spectrometry device should be a quadrupole mass spectrometer which can discriminate the charge state (mass-charge ratio) of a matter in vapor phase and efficiently and easily measure the type and amount of the matter in the exhaust gas. Here, the quadrupole mass spectrometer is a device which has four electrodes and measures the amount or so of a predetermined matter from the intensity spectrum of charge particles having a mass-charge ratio (m/z) which is acquired by applying positive and negative DC voltages and AC voltage to the electrodes by a predetermined ratio and changing the DC voltage (or AC voltage) linearly, and can pass between the electrodes.

In the first embodiment, the measuring section 24 monitors the concentration partial pressures of TiCl₄ and NH₃ and sends the control unit 12 an event when they reach predetermined partial pressures. However, the measuring section 24 may send detected partial pressure data to the control unit 12 and the control unit 12 may monitor the partial pressures and discriminate if they reach predetermined partial pressures.

In the first embodiment, it is described that the measuring section 24 measures the concentration partial pressures of TiCl₄ and NH₃ as process (source for film formation) gases. However, information about a predetermined matter for discriminating the internal status of the chamber is not limited to the concentration partial pressure but may be the amount or type of the fragment ions of a predetermined matter which indicates the dissociation status of the process gas and those may be detected by the measuring section 24.

In the first embodiment, a TiN film is formed on the top surface of a wafer using TiCl₄ and NH₃. But, the matters to be used and the type of a film to be deposited are not limited to them. Besides a TiN film, other metal films, such as AlO₂, ZrO₂, TaN, SiO₂, SiN, SiON, WN, WSi and RuO₂. In this case, as the types of gases to be used, any one of TaBr₅, Ta(OC₂H₅)₅, SiCl₄, SiH₄, Si₂H₆, SiH₂, Cl₂, WF₆, etc. can be used in place of TiCl₄ and any one of N₂, O₂, O₃, NO, N₂O, N₂O₃, N₂O₅, etc. can be used in place of NH₃.

The purge gas which is used to purge inside the chamber after forming a film of TiN or so with a predetermined thickness on a wafer is not limited to Ar but has only to be an inactive gas and nitrogen, neon or the like may be used.

The process system 11 according to the first embodiment may be connected to a process system which performs another process, such as annealing, in line or clustering.

Further, it is not limited to a single-wafer type process system 11 which performs a process on wafers one after another but may be adapted to a batch type process system.

The invention according to the first embodiment is not limited to ALD but can be adapted to all processes which use plural types of gases and need to switch the process atmosphere fast, such as another deposition process, oxidation, and etching.

### (Second Embodiment)

In the second embodiment, dry cleaning of a process system which deposits a silicon-based film of silicon oxide or so, on the top surface of a process target like a semiconductor wafer (hereinafter wafer) by a plasma process in a chamber is described as an example. Dry cleaning of the process system is carried out by introducing the plasma of a fluorine-based gas (nitrogen trifluoride (NF₃)) into the chamber.

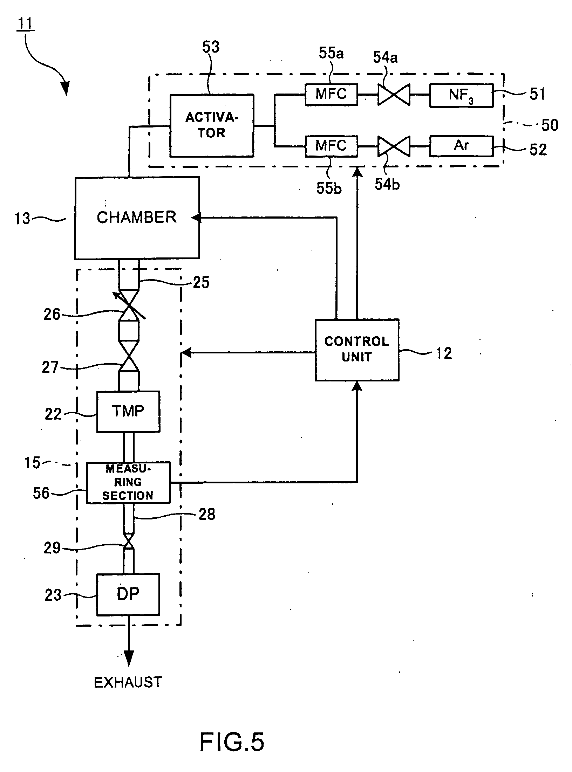

Fig. 5 shows the structure of a process system 11 according to the second embodiment. As shown in Fig. 5, the process system 11 has a control unit 12, a chamber 13, a cleaning gas supply line 50 and an exhaust line 15.

The control unit 12 controls the general operation of the process system 11, such as film deposition and cleaning, to be discussed later. To make understanding easier, the details of the operation of the control unit 12 are omitted.

The chamber 13 is constructed in such a way as to be vacuumable and a wafer as a process target is retained therein. The chamber 13 has an unillustrated plasma generating mechanism equipped with a high-frequency power supply or so and is constructed so as to be able to generate a plasma inside. The plasma generating mechanism causes a plasma process to be performed on the top surface of the wafer inside the chamber 13, thereby forming a silicon-based film of silicon oxide or so.

The cleaning gas supply line 50 has an NF₃ source 51 which supplies an NF₃ gas as the cleaning gas and an Ar source 52 which supplies an Ar gas as a diluted gas. The cleaning gas supply line 50 is provided with an activator 53 which activates the gas that passes inside the line. The NF₃ source 51 and the Ar source 52 are connected to the activator 53 via valves 54a and 54b and MFCs 55a and 55b.

The activator 53 has an unillustrated plasma generating mechanism and generates a high-density plasma of a gas passing inside, e.g., as an ECR (Electron Cyclotron Resonance) plasma, inductive coupled plasma (Inductive Coupled Plasma: ICP) or the like. The activator 53 sets a cleaning gas (NF₃), which passes inside, in a plasma state and exhausts the generated fluorine radicals selectively.

With the above-described structure, at the time of cleaning, the cleaning gas containing fluorine radicals as the essential component, is supplied into the chamber 13. Fluorine has a high combinability with respect to silicon, and a silicon-based film adhered and deposited in the chamber 13 is removed (etched) fast and effectively by the cleaning gas.

The exhaust line 15 has a turbo molecular pump (TMP) 22, a dry pump 23 (DP) and a measuring section 56. The exhaust line 15 is connected to the chamber 13 and the chamber 13 is pumped out via the exhaust line 15 to be depressurized to a predetermined pressure state.

The TMP 22 is connected to the chamber 13 via a first exhaust pipe 25. The first exhaust pipe 25 is provided with a variable flow rate valve 26 and a valve in order from the chamber 13. The TMP 22 depressurizes inside the chamber 13 to a predetermined vacuum state. The variable flow rate valve 26 keeps the interior of the chamber 13 at a predetermined vacuum state. The first exhaust pipe 25 has an inside diameter of about, for example, 50 mm in view of the exhaust speed, the length, etc. of the TMP 22.

The dry pump 23 is connected to the exhaust side of the TMP 22 by a second exhaust pipe 28. A valve is provided between the TMP 22 and the dry pump 23. The dry pump 23 serves as a roughing pump and sets inside the chamber 13 to a pressure at which the TMP 22 is operable. The exhaust side of the dry pump 23 is connected to an unillustrated harm eliminating device so that an exhaust gas which has passed the exhaust line 15 is made harmless and discharged out to the atmosphere.

The second exhaust pipe 28 has an inside diameter of about, for example, 40 mm in view of the exhaust speed, the length, etc. of the dry pump 23. Here, the dry pump 23 has a smaller exhaust capacity than the TMP 22 so that the second exhaust pipe 28 is smaller in diameter than the first exhaust pipe 25.

The measuring section 56 is attached to the second exhaust pipe 28 connected to the exhaust side of the TMP 22. The measuring section 56 measures the amount of particles in the gas flowing in the second exhaust pipe 28 during the process. The particles are generated as a film adhered and deposited in the chamber 13 becomes large to a certain degree and separated or so, and becomes a cause for reduction in yield. Therefore, it is possible to know the pollution status of the chamber 13 by monitoring the amount of particles in the exhaust gas.

When the amount of particles reaches a predetermined amount, the measuring section 56 which is monitoring the exhaust gas sends a signal indicating the event to the control unit 12. Based on the signal, the control unit 12 temporarily terminates deposition and starts a cleaning process. The measuring section 56 may be provided on either one of the supply side and the exhaust side of the valve.

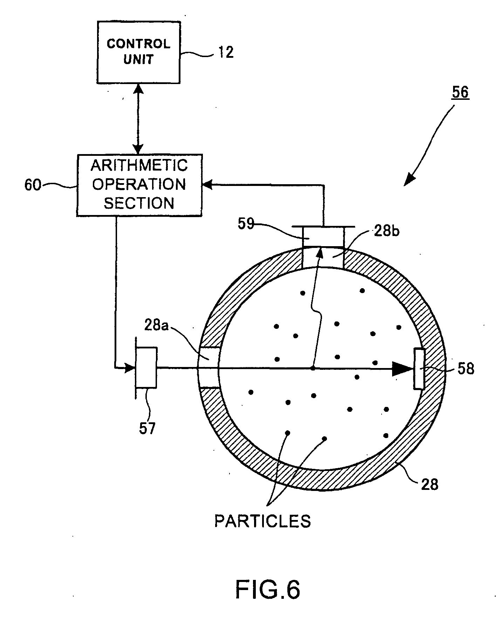

The structure of the measuring section 56 is illustrated in Fig. 6. As shown in Fig. 6, the measuring section 56 comprises a light source 57, a light stopper 58, a light sensor 59 and an arithmetic operation section 60.

The light source 57 is comprised of a laser diode or so and emits a laser beam. The light source 57 is disposed near the outer wall of the second exhaust pipe 28. A window portion 28a of quartz or crystal is provided in the second exhaust pipe 28. The laser beam emitted from the light source 57 is irradiated into the interior of the second exhaust pipe 28 via the window portion 28a. The light source 57 irradiates a laser beam in such a way that it passes nearly over the diameter of the second exhaust pipe 28. Any structure which causes the laser beam to pass in the pipe in whatever way besides over the diameter can be taken as long as the amount of particles in the gas flowing in the pipe can be observed quantitatively.

The light stopper 58 is laid out on the optical path of the laser beam on the inner wall of the second exhaust pipe 28. The light stopper 58 is comprised of a member which absorbs a laser beam and prevents reflection, e.g., a sapphire plate to which antireflection coating is applied. The light stopper 58 may be provided near the outer wall of the second exhaust pipe 28 in such a way that a laser beam is absorbed via a transparent window, like the aforementioned quarts, through which the laser beam can transmit.

The light sensor 59 is comprised of a light receiving element, such as a photodiode. The light sensor 59 is provided near the outer wall of the second exhaust pipe 28. A window portion 28b of quartz or crystal is provided in the pipe wall of the second exhaust pipe 28 in the vicinity of the light sensor 59. The window portion 28b is formed in such a way as to form an angle of approximately 90° with the window portion 28a on approximately the same plane whose normal line is in the lengthwise direction of the second exhaust pipe 28.

The light sensor 59 receives light scattered by particles in the exhaust gas that passes inside the second exhaust pipe 28. The light sensor 59 is connected to the arithmetic operation section 60 and outputs an electric pulse to the arithmetic operation section 60. Accordingly, the arithmetic operation section 60 acquires information about the amount of light received by the light sensor 59.

The arithmetic operation section 60 calculates the amount of particles from the amount of light received by the light sensor 59. When the computed amount of particles reaches a predetermined amount, the arithmetic operation section 60 connected to the control unit 12 sends a signal indicating the event to the control unit 12. Based on the received signal, the control unit 12 terminates the deposition process and starts a cleaning process.

Here, as described above, the measuring section 56 is provided on the exhaust side of the TMP 22. The pressure on the exhaust side of the TMP 22 (the second exhaust pipe 28) is high (the degree of vacuum is low) as compared with the inlet side (first exhaust pipe 25), so that the particle density in the vapor which passes inside the pipe becomes relatively large, yielding a high detection sensitivity.

As the pipe diameter is relatively small, a variation in the distribution of particles in the pipe is relatively small. Therefore, the distribution of particles on the optical path of the laser beam is relatively uniform, thus ensuring detection of the amount of particles with high reliability with a small variation or the like.

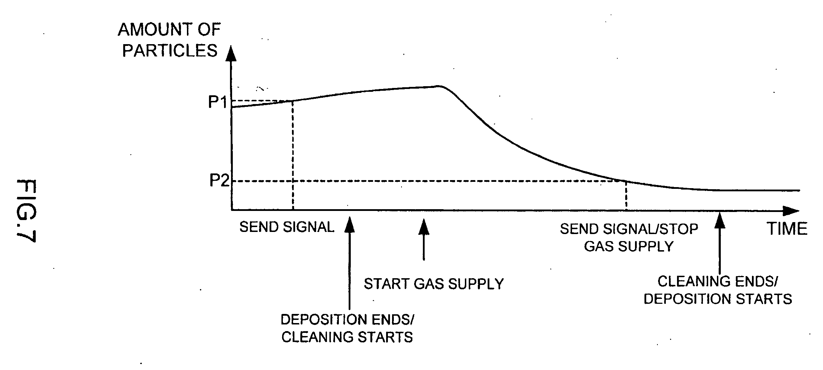

The operation of the process system 11 according to the second embodiment shown in Fig. 5 is described below referring to Fig. 7. The operation illustrated below is just an example and any structure may be taken as long as similar resultant products are acquired.

The process system 11 performs a plasma process on wafers in the chamber 13 one after another to deposit a silicon-based film (silicon oxide film) on the top surface of the wafer. The process system 11 continuously performs deposition on multiple wafers. While the process system 11 is operating, the measuring section 56 is monitoring the amount of particles in the exhaust gas.

According to the continuous deposition, the amount of particles generated in the chamber 13 increases gradually. When the amount of particles in the exhaust gas reaches a predetermined amount (P1) as shown in Fig. 7, the measuring section 56 sends a signal indicating the event to the control unit 12.

When receiving the signal, the control unit 12 temporarily terminates the deposition process with the wafer being subjected to the process then as the last one. After the last wafer is unloaded from the chamber 13, the control unit 12 starts a cleaning process. It is to be noted that the cleaning process may be started after processing of a predetermined number of wafers or all the wafers in the lot in which that wafer is included is finished after signal reception.

After the cleaning process starts, first, the control unit 12 loads a dummy wafer into the chamber 13. Then, inside the chamber 13 is depressurized to a predetermined degree of vacuum, e.g., 10² Pa (0.75 Torr), and the supply of the cleaning gas to the chamber 13 from the cleaning gas supply line 50 is started. The cleaning gas is supplied to at, for example, NF₃/Ar = 500 sccm/1000 sccm.

The supply of the cleaning gas dissolves the silicon-based film or so, which is adhered and deposited in the chamber 13 and becomes a cause for the particles, into silane tetrafluoride or the like and is removed. As shown in Fig. 7, therefore, the amount of particles included in the exhaust gas from the chamber 13 are reduced gradually.

When the amount of particles decreases to a predetermined amount (P2), the measuring section 56 sends a signal indicating the completion of cleaning to the control unit 12. Upon reception of the signal, the control unit 12 stops supplying the cleaning gas. After a time enough for the cleaning gas to be discharged from the chamber 13 elapses, the dummy wafer is unloaded from the chamber 13. The above completes the cleaning process and the control unit 12 initiates the deposition process again.

According to the second embodiment, as described above, information (the amount of particles) in the chamber 13 is acquired from the exhaust gas on the exhaust side of the TMP 22 and a process (cleaning) in the chamber 13 is controlled based on the acquired information. Because the pipe diameter is relatively small on the exhaust side of the TMP 22, a variation or so in measured value is avoided. Therefore, a high-precision process control based on highly reliable information is executed, making it possible to prevent excessive cleaning or shorten the cleaning time.

In the second embodiment, the measuring section 56 is provided directly in the second exhaust pipe 28. However, the second exhaust pipe 28 may be provided with a bypass pipe and the measuring section 56 may be provided in a midway in the bypass pipe.

The second embodiment takes the structure that controls the cleaning process based on the amount of particles. However, information for discriminating the pollution status in the chamber is not limited to the amount of particles in the exhaust gas but may be information about another pollutant such as metal contamination or the like, and cleaning may be started based on those information. Here, it is preferable that the device which analyzes metal contamination should be the aforementioned quadrupole mass spectrometer which can efficiently measure a metal element in vapor phase.

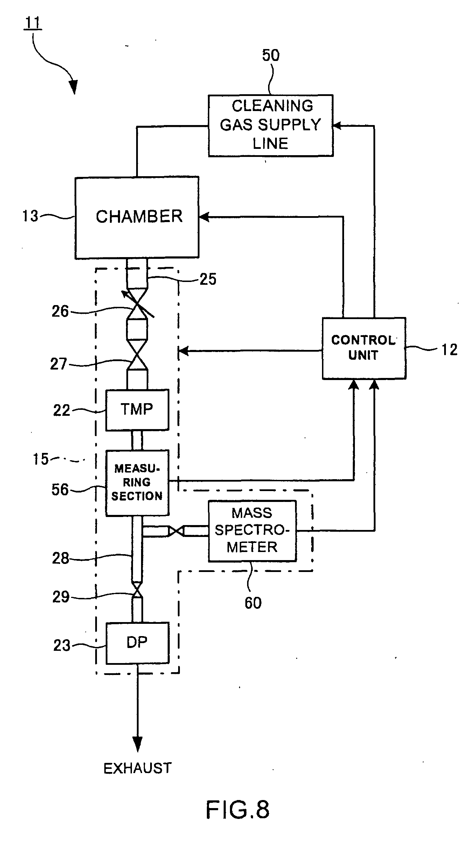

As shown in Fig. 8, a structure may be taken in such a way that a mass spectrometer, FT-IR or so is further provided to monitor the amount of a cleaning byproduct gas (e.g., silane tetrafluoride, oxygen or the like) which is produced as the deposited film is dissolved at the time of cleaning.

In the structure shown in Fig. 8, a mass spectrometer 61, such as a quadrupole mass spectrometer, which measures the amount of a cleaning byproduct, is disposed on the exhaust side of the measuring section 56 which measures the amount of particles. The mass spectrometer 61 may be provided on the supply side of the measuring section 56.

In the structure shown in Fig. 8, cleaning starts after the amount of particles becomes equal to or greater than a predetermined amount. At the time of cleaning, the amount of a cleaning byproduct during exhaust is monitored by the mass spectrometer 61.

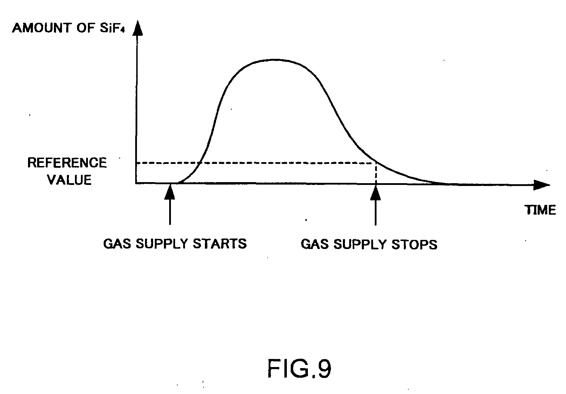

Fig. 9 schematically shows the variation profile of the cleaning byproduct (e.g., silane tetrafluoride (SiF₄)). As shown in Fig. 9, the amount of SiF₄ during exhaust increases as cleaning progresses but eventually turns to decrease. The control unit 12 stops the supply of the cleaning gas when the amount of SiF₄ drops to a predetermined amount.

In the second embodiment, the measuring section 56 monitors the amount of particles and when the amount reaches a predetermined amount, it sends the event to the control unit 12. However, the measuring section 56 may send the detected particle amount data to the control unit 12 and the control unit 12 may monitor the amount of particles and discriminate if it reaches a predetermined amount.

Further, it is not limited to a single-wafer type process system but may be adapted to a batch type process system.

The second embodiment has been described of a case where a silicon-based film, particularly, silicon fluoride oxide film, is deposited as an example. However, the type of a film to be deposited can be another silicon-based film such as a silicon oxide film, or any of other kinds of films.

In the second embodiment, a fluorine-based gas, particularly, NF₃, is used as a cleaning gas. However, the gas to be used in cleaning is not limited to this one. For example, a fluorine-based gas, such as F₂, SF₆, CF₄ or C₂F₆, in place of NF₃ or a chlorine-based gas, such as Cl₂ or BCl₄, can be used. Dilution may be done with, instead of Ar, another inactive gas, e.g., nitrogen, neon or so.

In the second embodiment, the plasma of a cleaning gas is introduced into the chamber 13. But, a structure may be taken in such a way that NF₃ as a cleaning gas is supplied into the chamber 13 to generate a plasma in the chamber 13.

The system according to the second embodiment is not limited to a plasma process system but can be adapted to other systems, such as an etching system, sputtering system and heat treatment system.

Various modifications or so may be made to the above-described embodiments by those skilled in the art without departing from the spirit and scope of the invention. The above-described embodiments are illustrative and do not limit the scope of the invention. Therefore, the scope of the invention is not to be referred to the above description, but should be decided along the entire equivalent ranges over which the right of the appended claims is granted.

The invention is based on Japanese Patent Application No. 2002-8465 (received on January 17, 2002) and includes the specification, claims, drawings and abstract of the application. The present specification incorporates the contents of the application entirely by reference.

### Industrial Applicability

In the above-described first and second embodiments, information regarding the interior of the chamber 13 is acquired at the exhaust side of the TMP 22 as the first exhaust means, and a process (ALD or cleaning) inside the chamber 13 is controlled based on the acquired information. Since the exhaust side of the first exhaust means has a relatively high pressure (a low vacuum pressure), the measuring sensitivity is improved, and since the pipe diameter at the exhaust side is relatively small, a variation in measured values can be restricted to a small level. Accordingly, based on the acquired information, a highly reliable process becomes available by high precision process control.

Further, the processing device and processing method according to the first embodiment can be applied to arbitrary processes such as other film deposition processes than ALD, oxidizing processes, etching processes, etc. in which plural kinds of gases are used and therefore the process atmosphere has to be switched fast.

Further, the processing device and processing method according to the second embodiment can be applied not only to a cleaning process utilizing a plasma process system, but also to other systems such as an etching system, a sputtering system, a heat treatment system, etc. and other processes.

The present invention can be applied not only to a semiconductor wafer, but also to a substrate for a liquid crystal display device.

As explained above, according to the present invention, it is possible to provide a processing device and processing method which can acquire predetermined information from an exhaust gas from a chamber and can perform a high precision process control based on the acquired information.

## Claims

1. A processing device (11) **characterized by** having:
process means (14, 50) which has a chamber (13) and performs a predetermined process on a process target in said chamber (13);
first exhaust means (22) which is connected to said chamber (13) and pumps inside said chamber (13) to a predetermined vacuum pressure;
second exhaust means (23) which is connected to said first exhaust means (22) and pumps inside said chamber (13) to a pressure at which said first exhaust means (22) is operable;
information acquisition means (24, 56, 61) which is arranged between said first exhaust means (22) and said second exhaust means (23) and acquires information about a predetermined matter in an exhaust gas exhausted from said chamber (13); and
control means (12) which discriminates a status inside said chamber (13) based on said information acquired by said information acquisition means (24, 56, 61) and controls said process means.

2. A processing device **characterized by** having:
a process section (14, 50) which has a chamber (13) and performs a predetermined process on a process target in said chamber (13);
a first exhaust section (22) which is connected to said chamber (13) via a first exhaust pipe (25) and pumps inside said chamber (13) to a predetermined vacuum pressure;
a second exhaust section (23) which is connected to an exhaust side of said first exhaust section (22) via a second exhaust pipe (28) smaller in diameter than said first exhaust pipe (25) and pumps inside said chamber (13) to a pressure at which said first exhaust section (22) is operable;
an information acquisition section (24, 56, 61) which acquires information about a predetermined matter in an exhaust gas exhausted from said chamber (13) and flowing in said second exhaust pipe (28); and
a control section (12) which discriminates a status inside said chamber (13) based on said information acquired by said information acquisition section (24, 56, 61) and controls said process section (14, 50).

3. The processing device according to claim 2, **characterized by** further having a measurement pipe (30) which is branched from said second exhaust pipe (28) and bypasses said exhaust gas flowing in said second exhaust pipe (28) and in that said information acquisition section (24, 56, 61) acquires said information from said exhaust gas flowing in said measurement pipe (30).

4. The processing device according to claim 2, **characterized in that** said information acquisition section (24, 56, 61) has an infrared spectroscopic analysis device (24) or a mass spectrometry device (61) which measures a concentration of said predetermined matter and said control section (12) controls said process section (14, 50) based on the concentration of said predetermined matter measured by said information acquisition section (24, 56, 61).

5. The processing device according to claim 2, **characterized in that** said information acquisition section (24, 56, 61) has an infrared spectroscopic analysis device (24) which measures a distribution of a fragment matter in said exhaust gas and said control section (12) controls said process section (14, 50) based on the distribution of said fragment matter measured by said information acquisition section (24, 56, 61).

6. A processing device **characterized by** having:
a chamber (13);
gas supply means (14, 50) which is connected to said chamber (13) and supplies one process gas in a plurality of process gases into said chamber (13) for a predetermined time;
first exhaust means (22) which is connected to said chamber (13) and pumps inside said chamber (13) to a predetermined vacuum pressure;
second exhaust means (23) which is connected to said first exhaust means (22) and pumps inside said chamber (13) to a pressure at which said first exhaust means (22) is operable;
measuring means (24, 56, 61) which is arranged between said first exhaust means (22) and said second exhaust means (23) and measures an amount of said process gas in an exhaust gas exhausted from said chamber (13); and
control means (12) which controls supply of another process gas by said gas supply means (14, 50) based on the amount of said process gas measured by said measuring means (24, 56, 61).

7. The processing device according to claim 6, **characterized in that** said control means (12) starts supplying another process gas into said chamber (13) by said gas supply means (14, 50) when the amount of said process gas in said exhaust gas is reduced to a predetermined amount.

8. A processing device **characterized by** having:
a chamber (13) in which a predetermined process is performed on a process target;
cleaning means (50) which cleans inside said chamber by supplying a cleaning gas for purifying inside said chamber (13);
first exhaust means (22) which is connected to said chamber (13) and pumps inside said chamber (13) to a predetermined vacuum pressure;
second exhaust means (23) which is connected to said first exhaust means (22) and pumps inside said chamber (13) to a pressure at which said first exhaust means (22) is operable;
information acquisition means (24, 56, 61) which is arranged between said first exhaust means (22) and said second exhaust means (23) and acquires information about a pollutant in an exhaust gas exhausted from said chamber (13); and
control means (12) which discriminates a pollution status inside said chamber (13) based on said information acquired by said information acquisition means (24, 56, 61) and controls said cleaning means (50).

9. The process system according to claim 6, **characterized in that** said pollutant is particles and said control means (12) cleans inside said chamber (13) when an amount of said particles in said exhaust gas becomes equal to or greater than a predetermined amount.

10. The process system according to claim 9, **characterized in that** said information acquisition means (24, 56, 61) has an optical counter (56) which measures the amount of particles in said exhaust gas.

11. The process system according to claim 6 or 9, **characterized in that** said information acquisition means (24, 56,61) further has byproduct measuring means (24, 61) which measures an amount of a byproduct produced by said cleaning in said exhaust gas, and
said control means (12) controls said cleaning means (50) based on the amount of said byproduct measured by said byproduct measuring means (24, 61).

12. The process system according to claim 6, **characterized in that** said information acquisition means (24, 56, 61) has a mass spectrometry device (61) which measures a type and an amount of a metal element in said exhaust gas, and said control means (12) controls said cleaning means (50) based on the type and amount of the metal element measured by said information acquisition means (24, 56, 61).

13. A process method having:
a process step which performs a predetermined process in a chamber retaining a process target inside,
a first exhaust step which causes a main exhaust section connected to said chamber to pump inside said chamber to a predetermined vacuum pressure, and
a second exhaust step which causes a sub exhaust section connected to said main exhaust section to pump inside said chamber to a pressure at which pumping in said first exhaust step is possible, **characterized by** having:
an information acquisition step which acquires information about a predetermined matter in an exhaust gas exhausted from said chamber in said first exhaust step and flowing between said main exhaust section and said sub exhaust section; and
a control step which discriminates a status inside said chamber and controls said process based on said information acquired in said information acquisition step.

14. A process method having:
a process step which performs a predetermined process in a chamber retaining a process target inside,
a first exhaust step which causes a main exhaust section connected via a first exhaust pipe to said chamber to pump inside said chamber to a predetermined vacuum pressure, **characterized by** having:
a second exhaust step which causes a sub exhaust section connected to said main exhaust section via a second exhaust pipe smaller in diameter than said first exhaust pipe to pump inside said chamber to a pressure at which pumping in said first exhaust step is possible;
an information acquisition step which acquires information about a predetermined matter in an exhaust gas exhausted from said chamber in said first exhaust step and flowing in said second exhaust pipe; and
a control step which discriminates a status inside said chamber and controls said process based on said information acquired in said information acquisition step.

15. The process method according to claim 14, **characterized in that** in said second exhaust step, inside said chamber is pumped out by the sub exhaust section connected to said main exhaust section via said second exhaust pipe and a measurement pipe for bypassing a gas flowing in said second exhaust pipe, and
in said information acquisition step, said information is acquired from said exhaust gas flowing in said measurement pipe.

16. The process method according to claim 14, **characterized in that** in said information acquisition step, a concentration of said predetermined matter is measured by an infrared spectroscopic analysis device or a mass spectrometry device and in said control step, said process is controlled based on said concentration measured in said information acquisition step.

17. A process method **characterized by** having:
a gas supply step which supplies one process gas in a plurality of process gases into a chamber retaining a process target inside for a predetermined time;
a first exhaust step which causes a main exhaust section connected to said chamber to pump inside said chamber to a predetermined vacuum pressure;
a second exhaust step which causes a sub exhaust section connected to said main exhaust section to pump inside said chamber to a pressure at which pumping in said first exhaust step is possible;
a measuring step which measures an amount of said process gas in an exhaust gas exhausted from said chamber in said first exhaust step and flowing between said main exhaust section and said sub exhaust section; and
a control step which controls supply of another process gas in said gas supply step based on the amount of said process gas measured in said measuring step.

18. A process method **characterized by** having:
a process step which performs a predetermined process in a chamber retaining a process target inside;
a cleaning step which cleans inside said chamber by supplying a cleaning gas for purifying inside said chamber;
a first exhaust step which causes a main exhaust section connected to said chamber to pump inside said chamber to a predetermined vacuum pressure, and
a second exhaust step which causes a sub exhaust section connected to said main exhaust section to pump inside said chamber to a pressure at which pumping in said first exhaust step is possible;
an information acquisition step which acquires information about a pollutant in an exhaust gas exhausted from said chamber in said first exhaust step and flowing between said main exhaust section and said sub exhaust section; and
a control step which discriminates a pollution status inside said chamber and controls cleaning in said chamber in said cleaning step based on said information acquired in said information acquisition step.
